# EUROPEAN PATENT SPECIFICATION

(11) **EP 2 559 063 B1**
(45) Date of publication and mention of the grant of the patent: **23.05.2018**
(21) Application number: 11717470.6
(22) Date of filing: 08.04.2011
(51) Int. Cl.: H01L 23/473

(54) **A FLOW DISTRIBUTOR**
FLUSSVERTEILER
RÉPARTITEUR DE FLUX

(30) Priority: 13.04.2010 DK 201000307
(43) Date of publication of application: 20.02.2013
(73) Proprietor: Danfoss Silicon Power GmbH, 24941 Flensburg (DE)
(72) Inventor: OLESEN, Klaus, DK-6400 Sønderborg (DK); PAULSEN, Lars, 25788 Hollingstedt (DE); STAACK, Andre, D-24848 Kropp (DE); OSTERWALD, Frank, D-24159 Kiel (DE)
(74) Representative: Inspicos P/S
(86) International application number: PCT/DK2011/000025
(87) International publication number: WO 2011/127931

(56) References cited:
- WO-A1-2006/056199

## Description

### FIELD OF THE INVENTION

The present invention relates to a flow distributor distributing coolant. In particular the present invention relates to a flow distribution module which provides more efficient and economic cooling that prior art distributors.

### BACKGROUND OF THE INVENTION

Power semiconductors are often mounted on substrates comprising an electrically insulating layer with a metal layer on each side. Power semiconductors may be mounted on a first side of the insulating layer with a first metal layer acting as a circuit to connect the various terminals of the semiconductors. Heat is generated by the semiconductors when they are in service, and this heat passes through the first metal layer, through the insulating layer and then through a second metal layer attached to the opposite side of the insulating layer. Heat can then be transported away from the semiconductors by use of, for example, a coolant which is in contact with the second metal layer. Whilst this can be sufficient in many applications, in some situations it is an advantage if the coolant can be transported as close as possible to the insulating layer in order to reduce the thermal path length and thus increase the rate of heat transfer away from the semiconductor.

It has been proposed that fluid flow channels be formed in the second metal layer and coolant can then be made to pass closer to the insulating layer. This solution has the disadvantage that traditionally the thickness of the metal layer was restricted to around a millimetre at most, resulting in very narrow channels with resulting increase in flow resistance and reduction in flow. Such channels were also liable to blockage and the resultant lowering in reliability.

A modification of the above solution is to build up a thick metal layer comprising several thin layers, each layer comprising a pattern of holes which, when assembled, formed a set of flow channels suitable for transporting coolant. Whilst an improvement, this solution still only allowed the formation of relatively narrow channels, with the above disadvantages. In addition the assembling of several metal layers is an expensive process, leading to a distinct commercial disadvantage of the known method.

WO 2006/056199 A1 discloses a flow distribution module for distributing a flow of cooling fluid across a surface. The flow distribution module comprises a housing, an inlet manifold, an outlet manifold, a plurality of flow cells, and a substrate having one or more surfaces to be cooled. The flow cells establish one or more fluid connections between the inlet manifold and the outlet manifold, and the flow cells are positioned in such a way that a flow of fluid passes along the surfaces to be cooled when fluid flows from the inlet manifold to the outlet manifold via the flow cells.

DE 39 08 996 A1 discloses a liquid cooler comprising a massive cooling element having cooling channels formed therein. The massive cooling element is made from an electrically insulating and thermally conductive material, such as a ceramic.

### SUMMARY OF THE INVENTION

It is an object of the invention to provide a flow distributor which is capable of providing more even cooling than known technology.

It is an additional object of the invention to provide a flow distributor which is capable of providing an improved cooling efficiency as compared to prior art flow distributors.

It is a further object of the invention to provide a flow distributor providing an improved heat transfer while maintaining a low pressure drop across the flow distributor.

It is an even further object of the invention to provide a flow distributor which is simpler and cheaper to manufacture than known flow distributors. According to the invention the above and other objects are fulfilled by providing a flow distributor for distributing a flow of fluid through a cooling body according to claim 1.

Such a flow distributor facilitates more even cooling of the insulating layer by virtue of the fact that each flow cell cools a small portion of the insulating layer and is supplied with coolant directly from the inlet manifold and discharges directly to the outlet manifold.

Additionally, since the flow distributor is formed directly within the solid layer there is a very short thermal path length from the insulating layer to be cooled to the coolant. The cooling efficiency of the flow distributor is therefore extremely high.

The method of bonding directly to the insulating layer may be by molten bonding, eutectic bonding or by other suitable method.

The fluid is preferably a liquid, but it may alternatively be a gas or a mixture of gas and liquid.

The flow distributor comprises an inlet manifold, an outlet manifold and one or more flow cells. The flow cells are each arranged to fluidly interconnect the inlet manifold and the outlet manifold. Thus, fluid is guided from the inlet manifold to the outlet manifold via one or more flow cells. The inlet manifold distributes fluid to the flow cells, and fluid from the flow cells is collected in the outlet manifold. The inlet manifold may advantageously be fluidly connected to a fluid source providing cold fluid. Similarly, the outlet manifold may advantageously be fluidly connected to a fluid drain for collecting fluid which has been guided through the flow cells. The fluid may be recirculated, in which case a heat exchanger may advantageously be arranged between the outlet manifold and the inlet manifold in order to avoid an increase in temperature of the fluid being guided through the flow cells.

The ceramic layer may have a thickness that is a compromise between ease of handling during manufacture and ease of transmission of heat generated by heat generating components that may be mounted on the side of the ceramic layer remote from the flow distributor. In one embodiment the thickness of the ceramic layer is 0.38 mm, such as between 0.2 mm and 0.5 mm, such as between 0.1 mm and 1 mm, such as between 0.01 mm and 10 mm.

Examples of suitable ceramics include silicon nitride, aluminium nitride and alumina.

The inlet manifold, the outlet manifold and the one or more flow cells may formed by die casting. Such a method is inexpensive compared with other methods of forming channels in solids, and therefore the flow distributor made in this manner is simpler and cheaper to produce than other comparable products.

The solid layer comprises aluminium or an aluminium alloy.

The thickness of the flow distributor is at least 0.5 mm, and may be 50 mm or more thick. Such a thickness enables the flow distributor to comprise wide passages thus providing an improved heat transfer while maintaining a low pressure drop across the flow distributor.

When a surface is cooled by guiding a laminar flow of fluid, such as a flow of liquid along the surface, a boundary layer is normally formed in the flowing fluid immediately adjacent to the surface. In the boundary layer the flow velocity is lower than the flow velocity of the remaining part of the cooling fluid. The thickness of the boundary layer increases along the flow direction of the fluid, and the combination of the increasing thickness of the boundary layer and the lower flow velocity causes the heat transfer, and thereby the cooling efficiency, of the system to decrease, in some cases drastically.

At least one flow cell may be so formed as to cause the fluid to repeatedly change direction when flowing from the cell inlet to the cell outlet. Such changes in flow direction as a fluid flows from the inlet manifold to the outlet manifold via the flow path cause disturbances of the flow pattern, thereby contributing to preventing formation of a boundary layer.

In addition, the inventive flow distributor may be adapted to be connected to another identical flow distributor in such a manner that the inlet manifold is connected to another identical inlet manifold to form a common fluid inlet, and in such a manner that the outlet manifold is connected to another identical outlet manifold to form a common fluid outlet, the flow distributor thereby being adapted to form part of a stack of flow distributors.

The inventive flow distributor may be adapted for different coolants such as water, oil, gas or even two-phase coolants where appropriate.

### BRIEF DESCRIPTION OF THE DRAWINGS

The invention will now be described in further detail with reference to the accompanying drawings in which
Fig 1 is a perspective view of a flow distributor according to a first embodiment of the invention,
Fig 2 is a perspective view of the same embodiment as Fig. 1,
Fig. 3 is a perspective view of the metal layer of the first embodiment of the current invention,
Fig. 4 shows the flow distributor in an assembled form,
Fig. 6 illustrates a perspective view of a second embodiment of the invention,
Fig. 7 illustrates yet another embodiment,
Fig. 8 illustrates a perspective view of a further embodiment of the invention,
Fig. 9 is a perspective view of the component side of the embodiment shown in Fig. 8 and
Fig. 10 is a perspective view of ten of the embodiments shown in Figs. 8 and 9 assembled to form a stack of flow distributors.

### DETAILED DESCRIPTION OF THE DRAWINGS

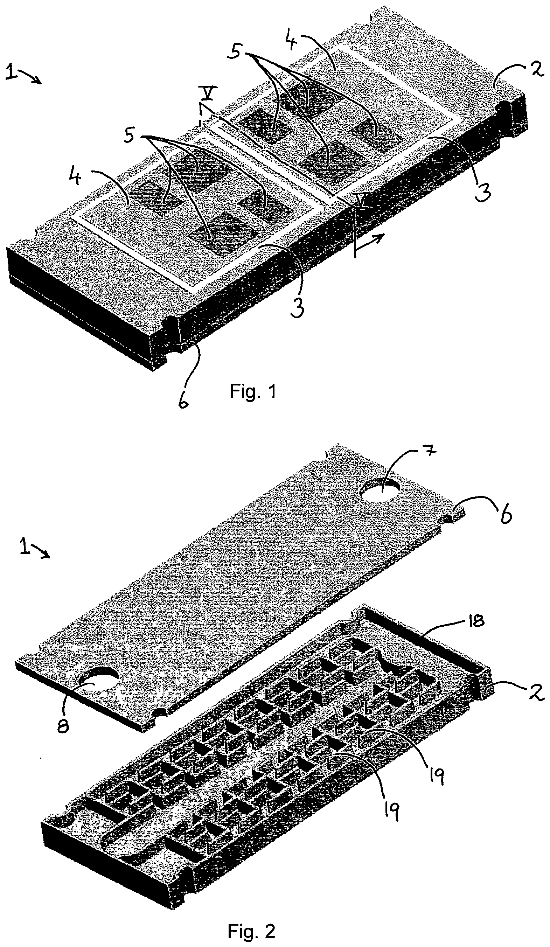

Fig 1. is a perspective view of a flow distributor 1 according to a first embodiment of the invention. The flow distributor 1 comprises a aluminium layer 2 upon one surface of which is bonded two ceramic layers 3. On the side away from the aluminium layer 2 both ceramic layers are attached to a further aluminium layer 4 on which are attached a number of power semiconductor components 5. Such power semiconductor components 5, when in service, produce heat which is conducted through the aluminium layer 4, the ceramic layer 3 and to the metal layer 2. The metal layer 2 is of a thickness of 10mm, although it may be of other thicknesses.

Fig 2. is a perspective view of the same embodiment as Fig 1, but this time the flow distributor 1 is viewed from the other direction, the ceramic layers 3 are not visible in this view, being on the opposite side of the distributor 1. What is visible in this figure, however, is the metal layer 2 and its internal structure. This structure comprises an outer wall 18 and several internal wall segments 19 dividing the area within the outer wall into spaces which become enclosed volumes when the plate 6 is placed over the outer wall 18. The internal structure will be more fully described below. Plate 6 is shown here in an 'exploded' position to allow the details of the internal structure of the metal layer 2 to be seen. Also visible here are two holes in the plate 6, the inlet 7 and outlet 8, through which coolant enters and leaves the distributor 1 respectively. The plate 6 is formed from aluminium or aluminium alloy, and is connected to the metal layer 2 when in position by brazing or welding. The plate 6 adds increased bending stiffness and pressure robustness to the completed design of flow distributor 1.

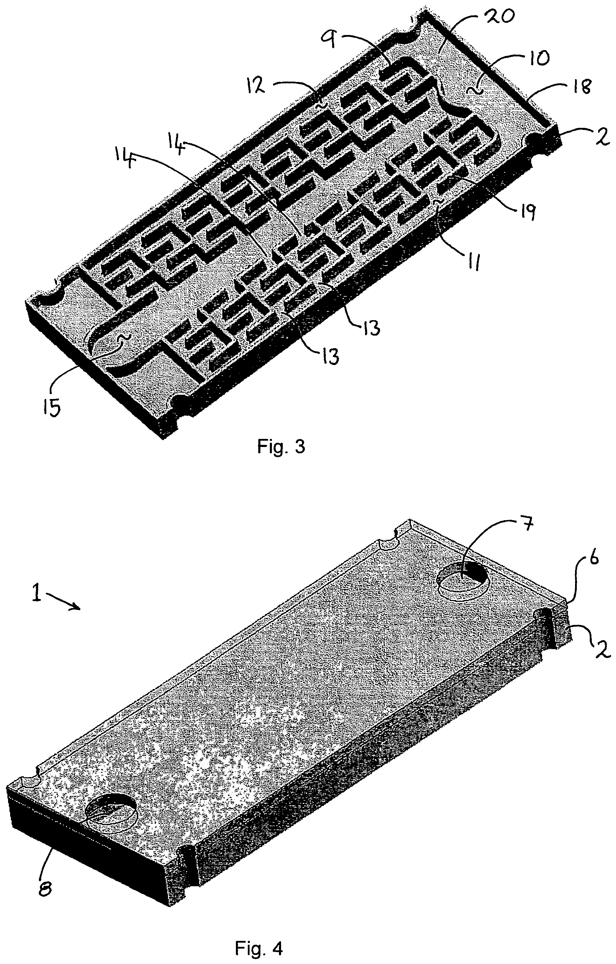

Fig. 3 is a perspective view of the metal layer 2 of the first embodiment of the current invention. In this view, drawn at a slightly different angle to those of Figs. 1 and 2 in order that the internal details are more visible. The metal layer 2 is formed by a die casting process. The metal layer 2 comprises a flat base plate 20 on the face adjacent to the ceramic layer 3 (not visible) from which walls extend in a direction away from the ceramic layer 3. These walls define the structure that guides coolant from the inlet 7 to the outlet 8. The thickness of the flat base plate 20 may be substantially less than the height of the walls 18 and 19. It is a distinct advantage for it to be then, since it will then form a shorter thermal path from the ceramic layer 3 to the coolant. The thickness of the flat base plate 20 can in fact be zero, where the areas between the walls extend as far as the surface of the ceramic layer 3 itself, and allowing the coolant to contact directly the ceramic layer and thus greatly enhancing the transfer of heat.

Coolant entering through the inlet 7 will be first received in the inlet manifold 10. From there it will travel through one of two side passages 11, 12 in fluid connection with the inlet manifold 10 and from there through one of sixteen flow cells each having an cell inlet 13 and an cell outlet 14 and which all deliver coolant from the cell inlet 13 to the cell outlet 14 via a meandering passage defined by the cell walls. All cell outlets are in fluid connection with the outlet manifold 15 which is in turn in fluid connection with the outlet 8.

It will be clearly understood that in moving from the inlet manifold 10 to the outlet manifold 15 the coolant will remove heat from the heat generating power semiconductors 5 mounted on the opposite side of the metal layer 2. It will also be apparent that the coolant will pass through only one flow cell in passing from the inlet manifold 10 to the outlet manifold 15. As a corollary, it will be seen that each flow cell obtains coolant directly from the inlet manifold 10, and thus the cooling effect will be maximised.

Fig. 4 shows the flow distributor 1 in an assembled form, the plate 6 having been attached to the metal layer 2.

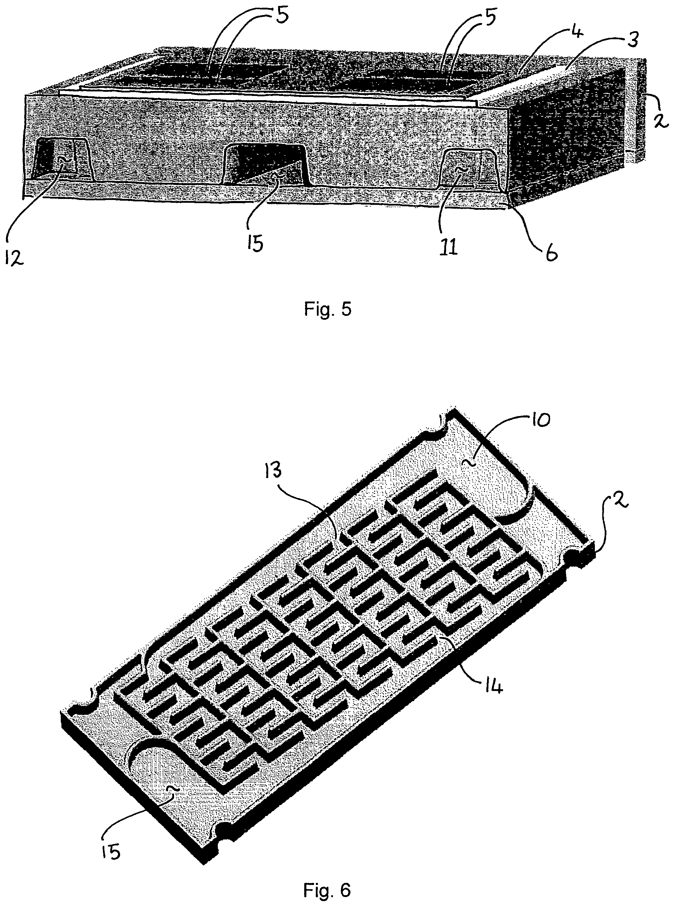

Fig. 5 shows a combined perspective and cross sectional view along the plane V-V in Fig. 1. Portions of the inlet manifold 11, 12 and the outlet manifold 15 are visible.

Fig. 6 illustrates a perspective view of a second embodiment of the invention. This embodiment is identical with the first embodiment with the exception of the pattern of flow cells. Here there are only 7 flow cells, each with an inlet 13 and an outlet 14.

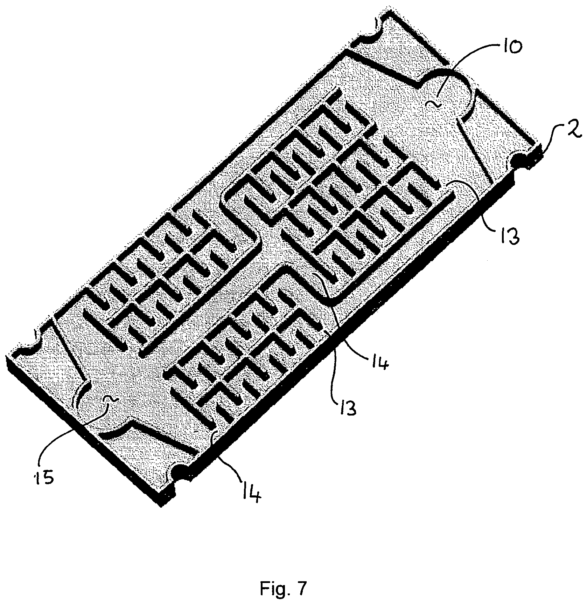

Fig. 7 illustrates yet another embodiment. Here there are seven flow cells again. The different flow cell patterns are designed to remove heat from specific configurations of power semiconductor components 5 on the reverse side of the metal layer 2.

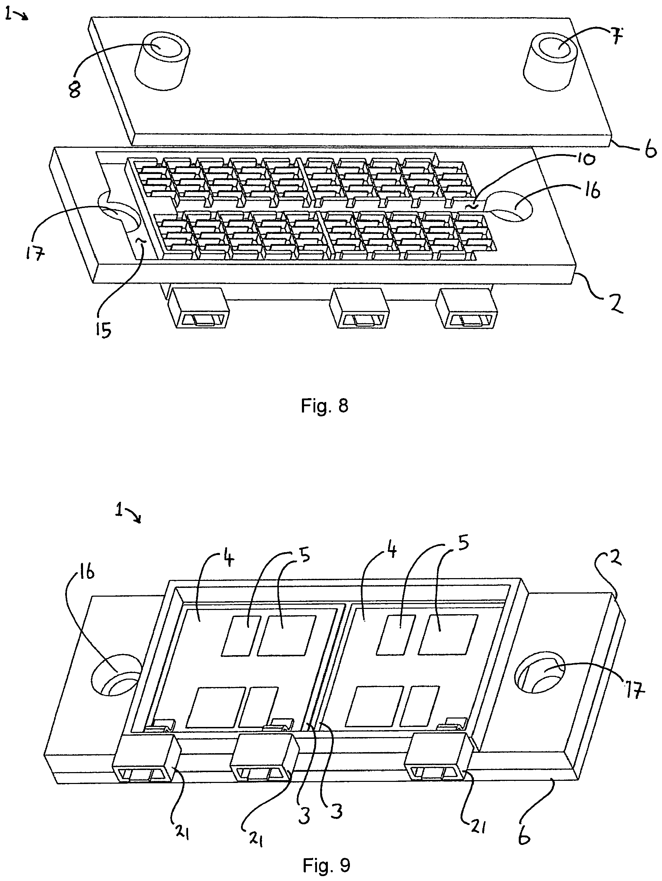

Fig. 8 illustrates a perspective view of a further embodiment of the invention. This embodiment is adapted to be connected to another at least substantially identical flow distributor 1 in such a manner that the inlet manifold 10 is connected to another at least substantially identical inlet manifold 10 to form a common fluid inlet, and in such a manner that the outlet manifold 15 is connected to another at least substantially identical outlet manifold 15 to form a common fluid outlet, the flow distributor 1 thereby being adapted to form part of a stack of flow distributors. To enable this to happen a second opening 16 is made in the inlet manifold 10 and a similar additional opening 17 is made in the outlet manifold 15. When the flow distributors 1 are stacked, these openings are in fluid communication with each other and thus form the common fluid inlets and outlets.

Fig. 9 is a perspective view of the component side of the embodiment shown in Fig. 8. Connectors 21 are electrical connectors to the circuitry associated with the power semiconductors 5.

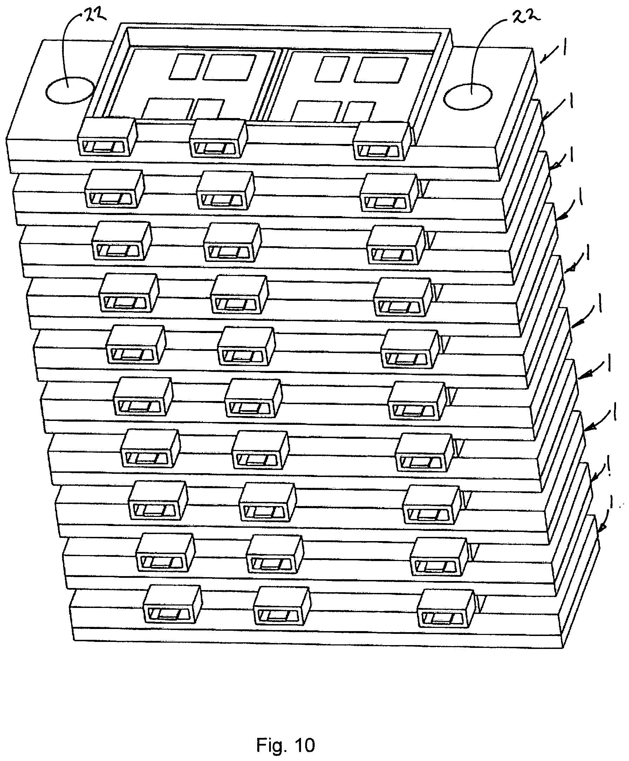

Fig. 10 is a perspective view of ten of the embodiments shown in figs. 8 and 9 assembled to form a stack of flow distributors. Here stoppers 22 are placed in the unused inlet and outlet on the top flow distributor to seal off the inlet and outlet manifolds. Coolant is brought into the system via an inlet at the opposite end of the stack (not shown) and leaves from an equivalent outlet.

The embodiments described above have been for the structure and use of a flow distributer for cooling a insulating layer and by that means the cooling of power semiconductor components. The invention is not restricted to being used to extract heat from a object, since, as will be clear to those well versed in the art of heat transfer, that the same technology may also be used to add heat to an object.

Although various embodiments of the present invention have been described and shown, the invention is not restricted thereto, but may also be embodied in other ways within the scope of the subject-matter defined in the following claims.

## Claims

1. A flow distributor (1) for distributing a flow of fluid through a cooling body, the flow distributor (1) comprising:
- an inlet manifold (10),
- an outlet manifold (15),
- one or more flow cells, each being arranged to fluidly interconnect the inlet manifold (10) and the outlet manifold (15), each flow cell comprising a cell inlet (13) in fluid communication with the inlet manifold (10), a cell outlet (14) in fluid communication with the outlet manifold (15), and a flow channel for guiding a flow of fluid from the cell inlet (13) to the cell outlet (14),
**characterised in that** the flow distributor (1) is formed within a solid aluminium layer (2) which is bonded directly to a ceramic layer (3) to be cooled, and **in that** a further aluminium layer (4) is attached to the ceramic layer (3) on the side away from the aluminium layer (2), a number of power semiconductor components (5) being attached to the further aluminium layer (4).

2. A flow distributor (1) according to claim 1 where the thickness of the ceramic layer (3) is 0.38 mm, such as between 0.2 mm and 0.5 mm, such as between 0.1 mm and 1 mm, such as between 0.01 mm and 10 mm.

3. A flow distributor (1) according to any of the preceding claims where the inlet manifold (10), the outlet manifold (15) and the one or more flow cells are formed by die casting.

4. A flow distributor (1) according to any of the preceding claims where the thickness of the flow distributor (1) is at least 0.5 mm

5. A flow distributor (1) according to any of the preceding claims where at least one flow cell is so formed as to cause the fluid to repeatedly change direction when flowing from the cell inlet (13) to the cell outlet (14).

6. A flow distributor (1) according to any of the preceding claims which is adapted to be connected to another identical flow distributor (1) in such a manner that the inlet manifold (10) is connected to another identical inlet manifold (10) to form a common fluid inlet, and in such a manner that the outlet manifold (15) is connected to another identical outlet manifold (15) to form a common fluid outlet, the flow distributor (1) thereby being adapted to form part of a stack of flow distributors.

## Patentansprüche

1. Flussverteiler (1) zum Verteilen eines Fluidflusses durch einen Kühlkörper, wobei der Flussverteiler (1) Folgendes umfasst:
- einen Einlassverteiler (10),
- einen Auslassverteiler (15),
- eine oder mehrere Flusszelle(n), wobei jede dafür angeordnet ist, den Einlassverteiler (10) und den Auslassverteiler (15) fluidmäßig miteinander zu verbinden, wobei jede Flusszelle einen Zelleneinlass (13) in Fluidverbindung mit dem Einlassverteiler (10), einen Zellenauslass (14) in Fluidverbindung mit dem Auslassverteiler (15) und einen Flusskanal zum Leiten eines Fluidflusses von dem Zelleneinlass (13) zu dem Zellenauslass (14) umfasst,
**dadurch gekennzeichnet, dass** der Flussverteiler (1) innerhalb einer massiven Aluminiumschicht (2) geformt ist, die unmittelbar mit einer zu kühlenden Keramikschicht (3) verbunden ist, und dadurch, dass eine weitere Aluminiumschicht (4) an der Keramikschicht (3) auf der von der Aluminiumschicht (2) entfernten Seite befestigt ist, wobei eine Anzahl von Leistungshalbleiterbausteinen (5) an der weiteren Aluminiumschicht (4) befestigt ist.

2. Flussverteiler (1) nach Anspruch 1, wobei die Dicke der Keramikschicht (3) 0,38 mm, wie beispielsweise zwischen 0,2 mm und 0,5 mm, wie beispielsweise zwischen 0,1 mm und 1 mm, wie beispielsweise zwischen 0,01 mm und 10 mm, beträgt.

3. Flussverteiler (1) nach einem der vorhergehenden Ansprüche, wobei der Einlassverteiler (10), der Auslassverteiler (15) und die eine oder die mehreren Flusszelle(n) durch Druckgießen geformt sind.

4. Flussverteiler (1) nach einem der vorhergehenden Ansprüche, wobei die Dicke des Flussverteilers (1) wenigstens 0,5 mm beträgt.

5. Flussverteiler (1) nach einem der vorhergehenden Ansprüche, wobei wenigstens eine Flusszelle so geformt ist, dass sie bewirkt, dass das Fluid wiederholt die Richtung ändert, wenn es von dem Zelleneinlass (13) zu dem Zellenauslass (14) fließt.

6. Flussverteiler (1) nach einem der vorhergehenden Ansprüche, der dafür eingerichtet ist, mit einem anderen identischen Flussverteiler (1) verbunden zu werden auf eine solche Weise, dass der Einlassverteiler (10) mit einem anderen Einlassverteiler (10) verbunden ist, um einen gemeinsamen Fluideinlass zu bilden, und auf eine solche Weise, dass der Auslassverteiler (15) mit einem anderen Auslassverteiler (15) verbunden ist, um einen gemeinsamen Fluidauslass zu bilden, wobei der Flussverteiler (1) dadurch dafür eingerichtet ist, einen Teil eines Stapels von Flussverteilern zu bilden.

## Revendications

1. Répartiteur de flux (1) servant à répartir un flux de fluide à travers un corps de refroidissement, le répartiteur de flux (1) comprenant :
- un collecteur d'entrée (10),
- un collecteur de sortie (15),
- une ou plusieurs cellules d'écoulement, étant chacune prévues pour relier mutuellement sur le plan fluidique le collecteur d'entrée (10) et le collecteur de sortie (15), chaque cellule d'écoulement comprenant une entrée de cellule (13) en communication fluidique avec le collecteur d'entrée (10), une sortie de cellule (14) en communication fluidique avec le collecteur de sortie (15), et un canal d'écoulement servant à guider un flux de fluide de l'entrée de cellule (13) à la sortie de cellule (14),
**caractérisé en ce que** le répartiteur de flux (1) est formé à l'intérieur d'une couche d'aluminium solide (2) qui est assemblée directement avec une couche de céramique (3) à refroidir, et **en ce qu'**une couche d'aluminium supplémentaire (4) est fixée à la couche de céramique (3) sur le côté distant vis-à-vis de la couche d'aluminium (2), un certain nombre de composants semi-conducteurs de puissance (5) étant fixés à la couche d'aluminium supplémentaire (4).

2. Répartiteur de flux (1) selon la revendication 1, dans lequel l'épaisseur de la couche de céramique (3) est de 0,38 mm, notamment comprise entre 0,2 mm et 0,5 mm, notamment comprise entre 0,1 mm et 1 mm, notamment comprise entre 0,01 et 10 mm.

3. Répartiteur de flux (1) selon l'une quelconque des revendications précédentes, dans lequel le collecteur d'entrée (10), le collecteur de sortie (15) et la ou les cellules de flux sont formés par coulée sous pression.

4. Répartiteur de flux (1) selon l'une quelconque des revendications précédentes, dans lequel l'épaisseur du répartiteur de flux (1) est d'au moins 0,5 mm.

5. Répartiteur de flux (1) selon l'une quelconque des revendications précédentes, dans lequel au moins une cellule d'écoulement est formée de façon à amener le fluide à changer de direction de manière répétée lorsqu'il s'écoule de l'entrée de cellule (13) à la sortie de cellule (14).

6. Répartiteur de flux (1) selon l'une quelconque des revendications précédentes, qui est conçu pour être raccordé à un autre répartiteur de flux (1) identique de telle sorte que le collecteur d'entrée (10) soit raccordé à un autre collecteur d'entrée (10) identique afin de former une entrée de fluide commune, et de telle sorte que le collecteur de sortie (15) soit raccordé à un autre collecteur de sortie (15) identique afin de former une sortie de fluide commune, le répartiteur de flux (1) étant ainsi apte à faire partie d'un empilement de répartiteurs de flux.
